# EUROPEAN PATENT SPECIFICATION

(11) **EP 2 811 648 B1**
(45) Date of publication and mention of the grant of the patent: **02.12.2015**
(21) Application number: 13170414.0
(22) Date of filing: 04.06.2013
(51) Int. Cl.: H03K 17/16, H02M 1/44

(54) **Method and arrangement for controlling semiconductor switch**
Verfahren und Anordnung zur Steuerung eines Halbleiterschalters
Procédé et agencement pour le contrôle d'un commutateur semi-conducteur

(43) Date of publication of application: 10.12.2014
(73) Proprietor: ABB Oy, 00380 Helsinki (FI)
(72) Inventor: Nousiainen, Lari, 00380 Helsinki (FI)
(74) Representative: Kolster Oy Ab

(56) References cited:
- US-A- 5 926 012
- US-A1- 2011 273 206
- US-A1- 2013 107 584

## Description

### Field of the invention

The invention relates to a method and an arrangement for controlling a semiconductor switch.

### Background of the invention

Gate-controlled semiconductor switches, such as normally off devices like MOSFETs (Metal Oxide Semiconductor Field-Effect Transistor) and IGBTs (Insulated-Gate Bipolar Transistor), or normally on devices like JFETs (Junction-gate Field-Effect Transistor), may be controlled by applying control voltages to the control electrode (e.g. gate electrode) of the device. When a normally off device is used as a switch, turn-on of the device may be accomplished by setting a gate electrode of the device to a positive voltage with respect to an emitter / source (depending on the device type in question) electrode. Similarly, when the device is turned off, a negative or zero voltage with respect to the emitter / source is applied to the gate. For a normally on device like JFET, either a positive-biased (p-type JFET) or a negative-biased (n-type JFET) gate-to-source voltage is applied to turn off the device.

The above switching of the semiconductor switch may be carried out with a driver circuit. The driver circuit may receive a switching command from a control circuitry or the like, which determines when the semiconductor switch should be operated, i.e. switched on or off. Typical driver circuits may thus drive the semiconductor switch in response to the switching command by providing suitable control voltages to the control electrode of the semiconductor switch. When a turn-on of an IGBT, for example, is commanded, the driver circuit applies a positive voltage to the gate with respect to the emitter. Similarly, when the component is to be turned off, a zero or negative voltage is applied to the gate to turn the device off. A series resistance, often called a gate resistance, may be connected between the control voltage sources and the gate electrode to limit the gate current to values safe for the circuitry. In addition, separate values of gate resistance may be used for turn-on and turn-off instants. A minimum value for the gate resistance is often given by the component manufacturer. This minimum value typically reflects the fastest switching speed the component withstands without destruction.

In practice, however, a higher value of gate resistance than the minimum value may be desirable. For example, in the case of a half-bridge-type configuration of semiconductor switches, such as IGBTs, in an inverter, for example, the input voltage of such an inverter may need to be limited well below a maximum-voltage rating of the IGBTs due to collector-to-emitter voltage peaking during an IGBT turn-off transient. This is disadvantageous because in photovoltaic (PV) applications, for example, a wide input voltage range of inverters would be desirable. The overvoltage problem originates from high rate-of-change of current in parasitic inductances of the circuitry. The parasitic inductances are dependent on the internal construction of the semiconductor switch package as well as on the layout of the external circuitry. The IGBT turn-off transient can be limited by increasing the gate turn-off resistance, which limits the rate-of-change of the collector current of the IGBT.

A problem related to the use of high gate resistance values is, however, that a high gate resistance makes the turn-off instant longer and, therefore, creates high switching losses in the semiconductor switch and thus lowers the overall efficiency of the equipment. The longer switching instant also creates unwanted additional delay in the operation of the semiconductor switch with respect to the switching command.

Document US 2011/273206 discloses a switching gate driver of an IGBT device comprising a resistor unit to control a gate current of the IGBT device and a voltage reader that outputs a control signal to control a variable resistor of the resistor unit according to a collector-emitter voltage of the IGBT device in question. The voltage reader at a turn-off operation of the IGBT decreases a gate discharge current of the IGBT device so that an IGBT spike voltage decreases.

### Brief description of the invention

An object of the invention is to provide a method and an apparatus for implementing the method so as to solve or at least alleviate the above problem. The object of the invention is achieved by a method and an arrangement that are characterized by what is stated in the independent claims. Preferred embodiments of the invention are described in the dependent claims.

The invention is based on the idea of using first a low-value gate turn-off resistance, when turning off a semiconductor switch connected in series with another semiconductor switch, essentially before the current begins to commutate from the semiconductor switch to the other (complementary) semiconductor switch, and then using a higher-value gate turn-off resistance essentially after the current begins to commutate from the semiconductor switch to the other semiconductor switch.

The solution of the invention provides the advantage that the voltage peaking during the turn-off of the semiconductor switch can be minimized without a significant increase in the turn-off losses of the semiconductor switch or without a significant increase in the switching delay.

### Brief description of the figures

The invention will now be explained in greater detail in connection with preferred embodiments and with reference to the attached drawings, in which:
Figure 1 shows a circuit diagram of a three-phase inverter according to an embodiment;
Figure 2 shows a circuit diagram of a driver circuit according to an embodiment;
Figure 3 shows a diagram of a simulated collector-to-emitter voltage of an IGBT during the turn-off process according to an embodiment; and
Figure 4 shows a diagram of a simulated gate-to-emitter voltage of an IGBT during the turn-off process according to an embodiment.

### Detailed description of the invention

The application of the invention is not restricted to any specific system, but it may be applied to various electric systems. In addition, the use of the invention is not restricted to any system utilizing a specific basic frequency or to any specific voltage level.

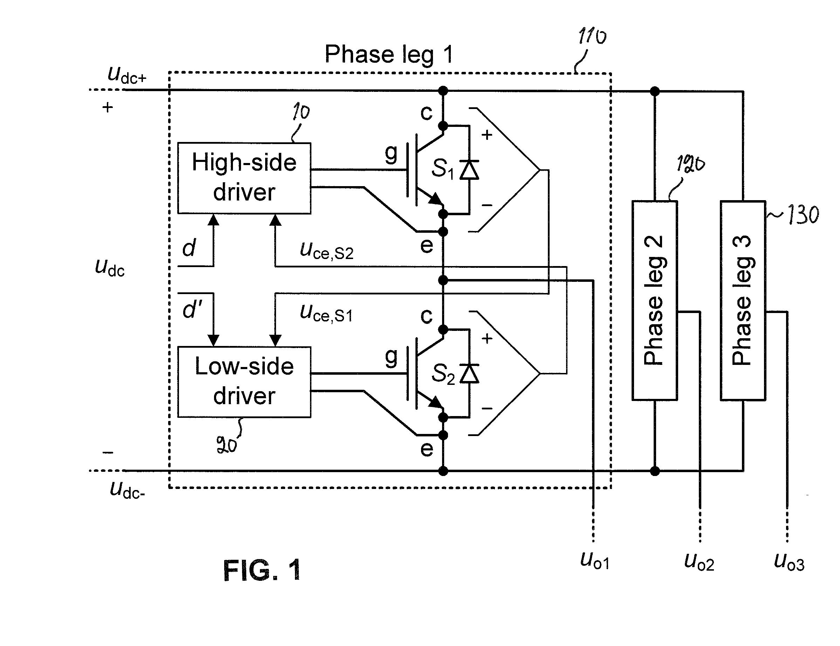

Figure 1 shows a circuit diagram of a three-phase inverter according to an embodiment. While the example of Figure 1 relates to a three-phase voltage source inverter (VSI), the invention may also be utilized in connection with single-phase inverters or two-phase inverters, or inverters having more than three phases, for example. The invention may also be utilized in connection with any converters comprising two semiconductor switches in a half-bridge-type configuration controlled on and off in a complementary manner. The inverter of Figure 1 comprises three phase legs 110, 120, 130, of which one 110 is shown in detail. The first phase leg 110 comprises two semiconductor switches S₁, S₂ connected in series between poles u_{dc+}, u_{dc-} of a DC voltage source providing voltage u_{dc}. The connection point of the semiconductor switches S₁, S₂ forms an AC output pole uₒ₁. The series connection of the semiconductor switches S₁, S₂ may be implemented with a half-bridge-type semiconductor switch module, for example. The other two phase legs 120, 130 may have a similar structure as the first phase leg 110 with corresponding AC output poles uₒ₂, uₒ₃. Each of the semiconductor switches S₁, S₂ may have an antiparallel diode connected across the switch as illustrated. Each of the semiconductor switches S₁, S₂ further comprises a control electrode, an input electrode and an output electrode. In the example of Figure 1, the control electrode is a gate g, the input electrode is a collector c and the output electrode is an emitter e. Thus, the semiconductor switches of the example of Figure 1 may be insulated gate bipolar transistors (IGBT), for example. However, depending on the type of the semiconductor, the control electrode may alternatively be a base, the input electrode may alternatively be a drain and/or the output electrode may alternatively be a source, for example. Possible examples of semiconductors, where the control electrode is a gate, the input electrode is a drain and the output electrode is a source, include field-effect transistors (FET), such as metal oxide semiconductor field-effect transistors (MOSFET), and junction gate field-effect transistors (JFET), such as silicon carbide junction gate field-effect transistors (SiC JFET). The type of the semiconductor switches is not, however, limited to any particular type. The first phase leg 110 further comprises driver circuits 10, 20 for each of the two semiconductor switches. The high-side driver 10 for the first semiconductor switch S₁ receives a duty ratio signal d from inverter control circuitry (not shown) and controls the first semiconductor switch S₁ on and off according to the duty ratio signal d. In a similar manner, the low-side driver 20 for the second semiconductor switch S₂ receives a complementary duty ratio signal d' from inverter control circuitry and controls the second semiconductor switch S₂ on and off according to the complementary duty ratio signal d'. The duty ratio signal d may be a pulse width-modulated square-wave signal, which has a variable duty ratio (0 to 100%, i.e. 0 to 1), and the complementary duty ratio signal d' is a complement of the duty ratio signal d. As a result, the first semiconductor switch S₁ and the second semiconductor switch S₂ are turned on and off in a complementary manner, i.e. when the first semiconductor switch S₁ is turned off, the second semiconductor switch S₂ is turned on, and when the first semiconductor switch S₁ is turned on, the second semiconductor switch S₂ is turned off.

According to an embodiment, the first semiconductor switch S₁ is turned off by providing a control voltage, which turns the first semiconductor switch S₁ off, through a resistance to the control electrode g of the first semiconductor switch S₁. The magnitude and polarity of a suitable control voltage, which turns the semiconductor switch off, depends on the type of the semiconductor switch in question. For example, the control voltage may be zero or a negative value when the semiconductor switch is a normally off device like a MOSFET or IGBT. For a normally on device like JFET, either a positive (p-type JFET) or a negative (n-type JFET) control voltage may be used to turn off the semiconductor switch. The control voltage provided to the control electrode g of the semiconductor switch is preferably indicated with respect to the output electrode e (e.g. emitter/source) of the semiconductor switch, i.e. the control voltage is a voltage with respect to the output electrode e (emitter/source) of the semiconductor switch. According to an embodiment, the resistance has a first value, when a voltage u_{ce,S2} between the input electrode c and the output electrode e of the second semiconductor switch S₂ is higher than a voltage threshold, and the resistance has a second value, when the voltage u_{ce,S2} between the input electrode c and the output electrode e of the second semiconductor switch S₂ is lower than the voltage threshold, wherein the second resistance value is higher than the first resistance value. In other words, during the turn-off of the first semiconductor switch S₁ (and essentially simultaneous turn-on of the second semiconductor switch S₂), the value of the resistance, through which the control voltage is provided to the control electrode g of the first semiconductor switch S₁, is changed from a lower value to a higher value when the voltage u_{ce,S2} between the input electrode c and the output electrode e of the second semiconductor switch S₂ goes below the voltage threshold. The voltage threshold may ideally be zero but in practice it may be a positive value, preferably a relatively low positive value, in order to compensate for operational delays in the driver circuitry. In addition, the voltage threshold is preferably below the voltage u_{dc} of the DC voltage source.

According to an embodiment, the second semiconductor switch S₂ is turned off by providing a control voltage, which turns the second semiconductor switch S₂ off, through a resistance to the control electrode g of the second semiconductor switch S₂. According to an embodiment, the resistance has a first value, when a voltage u_{ce,S1} between the input electrode c and the output electrode e of the first semiconductor switch S₁ is higher than the voltage threshold, and the resistance has a second value, when the voltage u_{ce,S1} between the input electrode c and the output electrode e of the first semiconductor switch S₁ is lower than the voltage threshold, wherein the second resistance value is higher than the first resistance value.

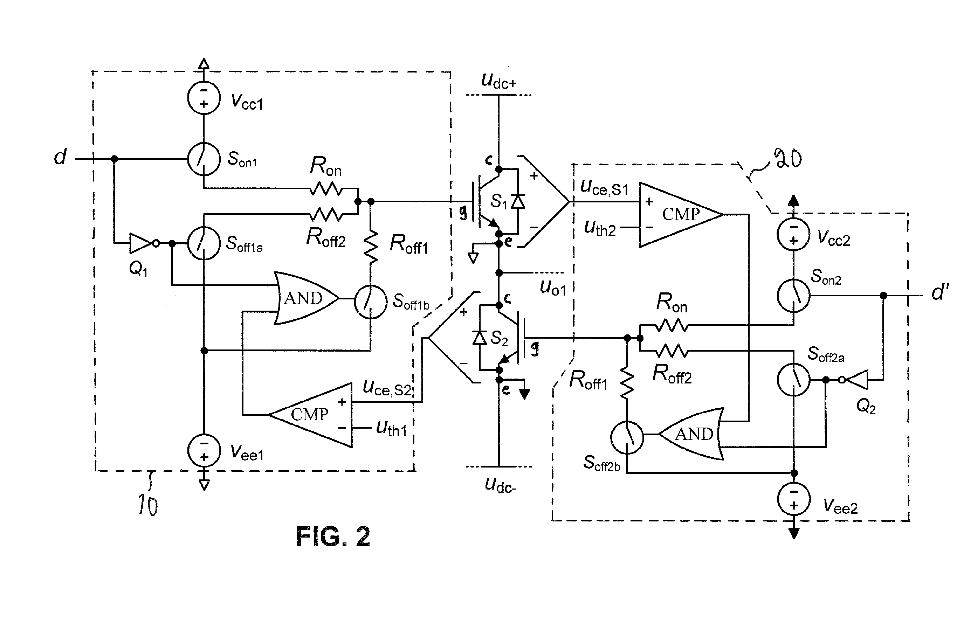

Figure 2 shows a circuit diagram of driver circuits according to an embodiment. In Figure 2, high-side and low-side driver circuits 10, 20 are illustrated in more detail according to an embodiment. It should be noted that Figure 2 merely shows an example of one possible implementation of the driver circuits 10, 20. The high-side driver circuit 10 inputs are the duty ratio d and the collector-to-emitter voltage u_{ce,S2} of the second semiconductor switch S₂. The low-side driver circuit 20 inputs are the complementary duty ratio d' and the collector-to-emitter voltage u_{ce,S1} of the first switch S₂. V_{cc1} and Vₑₑ₁ are supply voltages for the driver circuit 10 of the first semiconductor switch S₁ and are referenced to the emitter e of the first semiconductor switch S₁. V_{cc2} and Vₑₑ₂ are supply voltages for the driver circuit of the second semiconductor switch S₂ and are referenced to the emitter e of the second semiconductor switch S₂. Resistances R_{off1} and R_{off2} are turn-off resistances and resistance Rₒₙ is a turn-on resistance.

According to an embodiment, if in an initial condition the first semiconductor switch S₁ is on and the second semiconductor switch S₂ is off, then u_{ce,S1} = 0 V and u_{ce,S2} = u_{dc}. When the first semiconductor switch S₁ is turned off, the duty ratio signal d goes off, i.e. switch Sₒₙ₁ goes off and switch S_{off1a} and switch S_{off1b} go on (because of logic inverter Q₁) and the total turn-off gate resistance is a parallel connection of resistances R_{off1} and R_{off2}. Now u_{ce,S1} begins to rise toward u_{dc} and u_{ce,S2} to descend toward 0 V. The rate of change of a voltage du/dt is dependent on the turn-off gate resistance, i.e. the lower the resistance is, the faster the voltage changes. When this point is reached, the collector current of the first semiconductor switch S₁ starts to descend toward 0 A with a rate-of-change di/dt dependent on the turn-off gate resistance, i.e. the lower the gate resistance is, the faster the current changes. This rate of change of the current causes a voltage overshoot L*di/dt to appear between the collector and the emitter of the first semiconductor switch S₁, where L is a parasitic circuit inductance, i.e. u_{ce,S1} = u_{dc} + L*di/dt, while the current is descending. According to an embodiment, the turn-off gate resistance is changed at the point where the current starts to descend. The change of the value of the turn-off gate resistance of the first semiconductor switch S₁ may be implemented in such a way that, when u_{ce,S2} descends below the voltage threshold uₜₕ₁, comparator (CMP) output drops, and consequently the output of the AND gate also drops, and switch S_{off1b} goes off. Thereafter, the total turn-off gate resistance is R_{off2}. Now di/dt is dependent on resistance R_{off2}, not the parallel connection of resistances R_{off2} and R_{off1}, which has a lower resistance than resistance R_{off2} alone. Resistance R_{off1} preferably has a low value such that the voltage rise is fast, and resistance R_{off2} preferably has a higher value such that the current drop rate is limited to limit the voltage overshoot. The particular values for resistances R_{off2} and R_{off1} depend on the used semiconductor components, for instance. Therefore, no specific resistance values are given here. The voltage threshold uₜₕ₁ may be ideally 0 V (if circuit operations are infinitely fast). In practice, the voltage threshold may be a relatively small positive value below the normal dc-link voltage u_{dc} in order to compensate for delays in the circuit. With the circuit shown in Figure 2, the voltage rise is fast but still the current drop rate is limited in turn-off instants, which results in a relatively low voltage overshoot but only slightly increased turn-off switching losses.

According to an embodiment, if in an initial condition the second semiconductor switch S₂ is on and the first semiconductor switch S₁ is off, then u_{ce,S2} = 0 V and u_{ce,S1} = u_{dc}. When the second semiconductor switch S₂ is turned off, the complementary duty ratio signal d' goes off, i.e. switch Sₒₙ₂ goes off and switch S_{off2a} and switch S_{off2b} go on (because of logic inverter Q₂) and the total turn-off gate resistance is a parallel connection of resistances R_{off1} and R_{off2}. Now u_{ce,S2} begins to rise toward u_{dc} and u_{ce,S1} descends toward 0 V. When this point is reached, the collector current of the second semiconductor switch S₂ starts to descend toward 0 A with a rate-of-change di/dt dependent on the turn-off gate resistance. According to an embodiment, the turn-off gate resistance is changed at the point where the current starts to descend. The change of the value of the turn-off gate resistance of the second semiconductor switch S₂ may be implemented in such a way that, when u_{ce,S1} descends below the voltage threshold uₜₕ₂, comparator (CMP) output drops, and consequently the output of the AND gate also drops, and switch S_{off2b} goes off. Thereafter, the total turn-off gate resistance is R_{off2}. Now di/dt is dependent on resistance R_{off2}, not the parallel connection of resistances R_{off2} and R_{off1}, which has a lower resistance than resistance R_{off2} alone. Resistance R_{off1} preferably has a low value such that the voltage rise is fast and resistance R_{off2} preferably has a higher value such that the current drop rate is limited to limit the voltage overshoot. The particular values for resistances R_{off2} and R_{off1} depend on the used semiconductor components, for instance. Therefore, no specific resistance values are given here. The voltage threshold uₜₕ₂ may be ideally 0 V (if circuit operations are infinitely fast). In practice, the voltage threshold may be a relatively small positive value below the normal dc-link voltage u_{dc} in order to compensate for delays in the circuit.

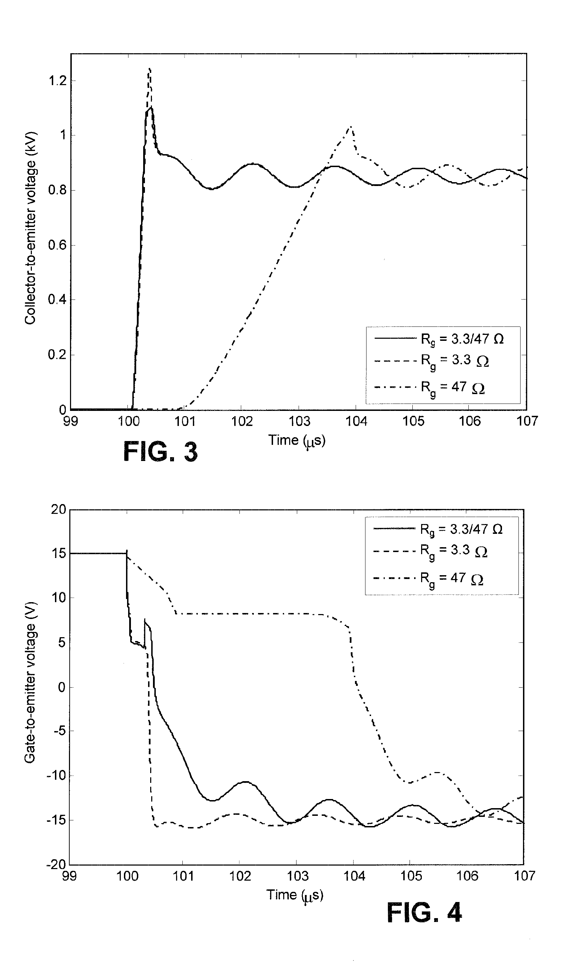

Figure 3 shows a simulated collector-to-emitter voltage of an IGBT during a turn-off process according to an embodiment. In Figure 3, the solid line shows the collector-to-emitter voltage of the IGBT during the turn-off process when the total turn-off gate resistance R_{g} is changed from 3.3 Ω to 47 Ω during the turn-off process using a circuit corresponding to that of Figure 2, for example. In addition, the dashed line shows the collector-to-emitter voltage of the IGBT during the turn-off process when the total turn-off gate resistance is kept constant at 3.3 Ω and the semi-dashed line shows the collector-to-emitter voltage of the IGBT during the turn-off process when the total turn-off gate resistance is kept constant at 47 Ω. As can be seen from the figure, the driver circuit of Figure 2 (Rg = 3.3/47 Ω) provides the high switching speed of a driver with a small turn-off resistance (Rg = 3.3 Ω) and the low voltage peaking of the driver with a high turn-off resistance (Rg = 47 Ω).

Figure 4 shows a simulated gate-to-emitter voltage of an IGBT during a turn-off process according to an embodiment. In Figure 4, the solid line shows the gate-to-emitter voltage of the IGBT during the turn-off process when the total turn-off gate resistance R_{g} is changed from 3.3 Ω to 47 Ω during the turn-off process using a circuit corresponding to that of Figure 2, for example. In addition, the dashed line shows the gate-to-emitter voltage of the IGBT during the turn-off process when the total turn-off gate resistance is kept constant at 3.3 Ω, and the semi-dashed line shows the gate-to-emitter voltage of the IGBT during the turn-off process when the total turn-off gate resistance is kept constant at 47 Ω. The semi-dashed line shows the effect of a low gate discharge current on the switching speed. The whole turn-off instant is significantly longer than with the other two drivers, which increases the turn-off losses among other negative side effects (decreased practical switching frequency, control-system operation etc.). The switching time of the variable resistance driver circuit (solid line) is slightly longer than with the low turn-off resistance (dashed line), which is a necessity if the rate-of-change of current is decreased. The change of the gate resistance is shown as a peak in the solid line at approximately 100.2 µs, and thereafter the solid and dashed lines have a similar behavior. The simulated turn-off losses and voltage-peaking properties of the three driver circuits with different total turn-off gate resistances are collected into following Table 1. As can be seen from the table, the variable resistance driver circuit has the best sides of low and high turn-off resistances; the turn-off losses are nearly as small as with the low turn-off resistance but the voltage peaking is significantly reduced.

**Table 1**

| Driver circuit | *R*_{g} = 3.3/47 Ω | *R*_{g} = 3.3 Ω | *R*_{g} = 47 Ω |
|---|---|---|---|
| Turn-off loss | 104 mJ | 101 mJ | 538 mJ |
| Voltage peak | 1100 V | 1245 V | 1032 V |

According to an embodiment, the comparator CMP in the circuit of Figure 2 could be tuned to trigger to a certain threshold voltage over the switch turned off. In such an operation the gate resistance is changed only if the turn-off transient voltage exceeds a pre-specified safe limit, i.e. 1000 V in the case of 1200 V IGBT, for example.

The driver circuit 10, 20 or a corresponding control arrangement driving the controllable semiconductor switches according to any one of the above embodiments, or a combination thereof, can be implemented as one unit or as two or more separate units that are configured to implement the functionality of the various embodiments. Here the term 'unit' refers generally to a physical or logical entity, such as a physical device or a part thereof or a software routine. The driver circuit 10, 20 or a corresponding control arrangement according to any one of the embodiments may be implemented at least partly by means of one or more computers or corresponding digital signal processing (DSP) equipment provided with suitable software, for example. Such a computer or digital signal processing equipment preferably comprises at least a working memory (RAM) providing a storage area for arithmetical operations, and a central processing unit (CPU), such as a general-purpose digital signal processor. The CPU may comprise a set of registers, an arithmetic logic unit, and a CPU control unit. The CPU control unit is controlled by a sequence of program instructions transferred to the CPU from the RAM. The CPU control unit may contain a number of microinstructions for basic operations. The implementation of microinstructions may vary depending on the CPU design. The program instructions may be coded by a programming language, which may be a high-level programming language, such as C, Java, etc., or a low-level programming language, such as a machine language, or an assembler. The computer may also have an operating system which may provide system services to a computer program written with the program instructions. The computer or other apparatus implementing the invention, or a part thereof, may further comprise suitable input means for receiving e.g. measurement and/or control data, and output means for outputting e.g. control data. It is also possible to use analog circuits, programmable logic devices (PLD), such as a field-programmable gate array (FPGA), or discrete electric components and devices for implementing the functionality according to any one of the embodiments. For example, the driver circuit 10, 20 or a corresponding control arrangement according to any one of the embodiments may be implemented at least partly by means of such analog circuits or programmable logic devices, such as an FPGA circuit. An FPGA circuit or another type of a programmable logic device, for example, may be used to implement the logical functions according to any one of the embodiments.

The invention can be implemented in existing system elements or by using separate dedicated elements or devices in a centralized or distributed manner. Present converters, for example, can comprise programmable logic devices, such as FPGA circuits, or processors and memory that can be utilized in the functions according to embodiments of the invention. Thus, all modifications and configurations required for implementing an embodiment of the invention e.g. in existing converters may be performed as software routines, which may be implemented as added or updated software routines. If at least part of the functionality of the invention is implemented by software, such software can be provided as a computer program product comprising computer program code which, when run on a computer, causes the computer or a corresponding arrangement to perform the functionality according to the invention as described above. Such a computer program code may be stored or generally embodied on a computer readable medium, such as a suitable memory, e.g. a flash memory or an optical memory, from which it is loadable to the unit or units executing the program code. In addition, such a computer program code implementing the invention may be loaded to the unit or units executing the computer program code via a suitable data network, for example, and it may replace or update a possibly existing program code.

It is obvious to a person skilled in the art that, as technology advances, the basic idea of the invention may be implemented in various ways. The invention and its embodiments are thus not restricted to the above examples but may vary within the scope of the claims.

## Claims

1. A method for controlling a first semiconductor switch, which first semiconductor switch (S₁) is connected in series with a second semiconductor switch (S₂) between poles (u_{dc+}, u_{dc-}) of a DC voltage source, each of the semiconductor switches comprising a control electrode (g), an input electrode (c) and an output electrode (e), wherein the method comprises:
turning the first semiconductor switch (S₁) off by providing a control voltage, which turns the first semiconductor switch off, through a resistance (R_{off1}, R_{off2}) to the control electrode (g) of the first semiconductor switch, **characterised in that** the resistance (R_{off1}, R_{off2}) has a first value, when a voltage (u_{ce,S2}) between the input electrode (c) and the output electrode (e) of the second semiconductor (S₂) switch is higher than a voltage threshold, and **in that** the resistance (R_{off1}, R_{off2}) has a second value, when the voltage between the input electrode (c) and the output electrode (e) of the second semiconductor switch (S₂) is lower than the voltage threshold, wherein the second resistance value is higher than the first resistance value.

2. A method according to claim 1, **characterised in that** the voltage threshold is zero or a positive value below a voltage (u_{dc}) of the DC voltage source.

3. A method according to claim 1 or 2, **characterised in that** the control electrode is a gate (g), the input electrode is a collector (c) and the output electrode is an emitter (e).

4. A method according to claim 3, **characterised in that** the semiconductor switches (S₁, S₂) are insulated gate bipolar transistors.

5. A method according to claim 4, **characterised in that** the control voltage is zero or a negative value.

6. A method according to claim 1 or 2, **characterised in that** the control electrode is a gate, the input electrode is a drain and the output electrode is a source.

7. A method according to claim 6, **characterised in that** the semiconductor switches (S₁, S₂) are metal oxide semiconductor field-effect transistors or junction gate field-effect transistors.

8. An arrangement for controlling a first semiconductor switch, which first semiconductor switch (S₁) is connected in series with a second semiconductor switch (S₂) between poles (u_{dc+}, u_{dc-}) of a DC voltage source, each of the semiconductor switches comprising a control electrode (g), an input electrode (c) and an output electrode (e), wherein the arrangement comprises:
means for turning the first semiconductor switch (S₁) off by providing a control voltage, which turns the first semiconductor switch off, through a resistance (R_{off1}, R_{off2}) to the control electrode of the first semiconductor switch, **characterised in that** the resistance (R_{off1}, R_{off2}) is configured to have a first value, when a voltage (u_{ce,S2}) between the input electrode and the output electrode of the second semiconductor switch (S₂) is higher than a voltage threshold, and **in that** the resistance (R_{off1}, R_{off2}) is configured to have a second value, when the voltage between the input electrode (c) and the output electrode (e) of the second semiconductor switch (S₂) is lower than the voltage threshold, wherein the second resistance value is higher than the first resistance value.

9. An arrangement according to claim 8, **characterised in that** the voltage threshold is zero or a positive value below a voltage of the DC voltage source.

10. An arrangement according to claim 8 or 9, **characterised in that** the control electrode is a gate (g), the input electrode is a collector (c) and the output electrode is an emitter (e).

11. An arrangement according to claim 10, **characterised in that** the semiconductor switches (S₁, S₂) are insulated gate bipolar transistors.

12. An arrangement according to claim 11, **characterised in that** the control voltage is zero or a negative value.

13. An arrangement according to claim 8 or 9, **characterised in that** the control electrode is a gate, the input electrode is a drain and the output electrode is a source.

14. An arrangement according to claim 13, **characterised in that** the semiconductor switches (S₁, S₂) are metal oxide semiconductor field-effect transistors or junction gate field-effect transistors.

15. An arrangement according to any one of claims 8 to 13, **characterised in that** the arrangement is a driver circuit (10, 20).

## Patentansprüche

1. Verfahren zum Steuern eines ersten Halbleiterschalters, wobei der erste Halbleiterschalter (S₁) in Reihe mit einem zweiten Halbleiterschalter (S₂) zwischen Polen (U_{dc+}, U_{dc-}) einer Gleichspannungsquelle verbunden ist, jeder der Halbleiterschalter eine Steuerelektrode (g), eine Eingangselektrode (c) sowie eine Ausgangselektrode (e) umfasst und das Verfahren umfasst:
Öffnen des ersten Halbleiterschalters (S₁) durch Zuführen einer Steuerspannung, die den ersten Halbleiterschalter öffnet, über einen Widerstand (R_{off1}, R_{off2}) zu der Steuerelektrode (g) des ersten Halbleiterschalters, **dadurch gekennzeichnet, dass** der Widerstand (R_{off1}, R_{off2}) einen ersten Wert hat, wenn eine Spannung (U_{ce, S2}) zwischen der Eingangselektrode (c) und der Ausgangselektrode (e) des zweiten Halbleiterschalters (S₂) höher ist als ein Spannungs-Schwellenwert, und dadurch, dass der Widerstand (R_{off1}, R_{off2}) einen zweiten Wert hat, wenn die Spannung zwischen der Eingangselektrode (c) und der Ausgangselektrode (e) des zweiten Halbleiterschalters (S₂) niedriger ist als der Spannungs-Schwellenwert, und der zweite Widerstandswert höher ist als der erste Widerstandswert.

2. Verfahren nach Anspruch 1, **dadurch gekennzeichnet, dass** der Spannungs-Schwellenwert Null oder ein positiver Wert unterhalb einer Spannung (U_{dc}) der Gleichspannungsquelle ist.

3. Verfahren nach Anspruch 1 oder 2, **dadurch gekennzeichnet, dass** die Steuerelektrode ein Gate (g) ist, die Eingangselektrode ein Kollektor (c) ist und die Ausgangselektrode ein Emitter (e) ist.

4. Verfahren nach Anspruch 3, **dadurch gekennzeichnet, dass** die Halbleiterschalter (S₁, S₂) Bipolartransistoren mit isoliertem Gate sind.

5. Verfahren nach Anspruch 4, **dadurch gekennzeichnet, dass** die Steuerspannung Null oder ein negativer Wert ist.

6. Verfahren nach Anspruch 1 oder 2, **dadurch gekennzeichnet, dass** die Steuerelektrode ein Gate ist, die Eingangselektrode ein Drain ist und die Ausgangselektrode eine Source ist.

7. Verfahren nach Anspruch 6, **dadurch gekennzeichnet, dass** die Halbleiterschalter (S₁, S₂) Metalloxidhalbleiter-Feldeffekttransistoren oder Sperrschicht-Feldeffekttransistoren sind.

8. Anordnung zum Steuern eines ersten Halbleiterschalters, wobei der erste Halbleiterschalter (S₁) in Reihe mit einem zweiten Halbleiterschalter (S₂) zwischen Polen (U_{dc+}, U_{dc-}) einer Gleichspannungsquelle verbunden ist, jeder der Halbleiterschalter eine Steuerelektrode (g), eine Eingangselektrode (c) sowie eine Ausgangselektrode (e) umfasst, und die Anordnung umfasst:
eine Einrichtung, mit der der erste Halbleiterschalter (S₁) geöffnet wird, indem der Steuerelektrode des ersten Halbleiterschalters über einen Widerstand (R_{off1}, R_{off2}) eine Steuerspannung zugeführt wird, die den ersten Halbleiterschalter öffnet, **dadurch gekennzeichnet, dass** der Widerstand (R_{off1}, R_{off2}) so eingerichtet ist, dass er einen ersten Wert hat, wenn eine Spannung (U_{ce}, _{S2}) zwischen der Eingangselektrode und der Ausgangselektrode des zweiten Halbleiterschalters (S₂) höher ist als ein Spannungs-Schwellenwert, und dadurch, dass der Widerstand (R_{off1}, R_{off2}) so eingerichtet ist, dass er einen zweiten Wert hat, wenn die Spannung zwischen der Eingangselektrode (c) und der Ausgangselektrode (e) des zweiten Halbleiterschalters (S₂) niedriger ist als der Spannungs-Schwellenwert, wobei der zweite Widerstandswert höher ist als der erste Widerstandswert.

9. Anordnung nach Anspruch 8, **dadurch gekennzeichnet, dass** der Spannungs-Schwellenwert Null oder ein positiver Wert unterhalb einer Spannung (U_{dc}) der Gleichspannungsquelle ist.

10. Anordnung nach Anspruch 8 oder 9, **dadurch gekennzeichnet, dass** die Steuerelektrode ein Gate (g) ist, die Eingangselektrode ein Kollektor (c) ist und die Ausgangselektrode ein Emitter (e) ist.

11. Anordnung nach Anspruch 10, **dadurch gekennzeichnet, dass** die Halbleiterschalter (S₁, S₂) Bipolartransistoren mit isoliertem Gate sind.

12. Anordnung nach Anspruch 11, **dadurch gekennzeichnet, dass** die Steuerspannung Null oder ein negativer Wert ist.

13. Anordnung nach Anspruch 8 oder 9, **dadurch gekennzeichnet, dass** die Steuerelektrode ein Gate ist, die Eingangselektrode ein Drain ist und die Ausgangselektrode eine Source ist.

14. Anordnung nach Anspruch 13, **dadurch gekennzeichnet, dass** die Halbleiterschalter (S₁, S₂) Metalloxidhalbleiter-Feldeffekttransistoren oder Sperrschicht-Feldeffekttransistoren sind.

15. Anordnung nach einem der Ansprüche 8 bis 13, **dadurch gekennzeichnet, dass** die Anordnung eine Ansteuerschaltung (10, 20) ist.

## Revendications

1. Procédé pour contrôler un premier commutateur semi-conducteur, lequel le premier commutateur semi-conducteur (S₁) est relié en série à un second commutateur semi-conducteur (S₂) entre les pôles (u_{dc+}, u_{dc-}) d'une source de tension à courant continu, chacun des commutateurs semi-conducteurs comportant une électrode de contrôle (g), une électrode d'entrée (c) et une électrode de sortie (e), dans lequel le procédé comporte :
la coupure du premier commutateur semi-conducteur (S₁) en délivrant une tension de contrôle, qui coupe le premier commutateur semi-conducteur, par l'intermédiaire d'une résistance (R_{off1}, R_{off2}) à l'électrode de contrôle (g) du premier commutateur semi-conducteur, **caractérisé en ce que** la résistance (R_{off1}, R_{off2}) possède une première valeur, lorsqu'une tension (u_{ce,S2}) entre l'électrode d'entrée (c) et l'électrode de sortie (e) du second commutateur semi-conducteur (S₂) est supérieure à un seuil de tension, et **en ce que** la résistance (R_{off1}, R_{off2}) possède une seconde valeur, lorsque la tension entre l'électrode d'entrée (c) et l'électrode de sortie (e) du second commutateur semi-conducteur (S₂) est inférieure au seuil de tension, dans lequel la seconde valeur de résistance est supérieure à la première valeur de résistance.

2. Procédé selon la revendication 1, **caractérisé en ce que** le seuil de tension est zéro ou une valeur positive en dessous d'une tension (u_{dc}) de la source de tension à courant continu.

3. Procédé selon la revendication 1 ou 2, **caractérisé en ce que** l'électrode de contrôle est une grille (g), l'électrode d'entrée est un collecteur (c) et l'électrode de sortie est un émetteur (e).

4. Procédé selon la revendication 3, **caractérisé en ce que** les commutateurs semi-conducteurs (S₁, S₂) sont des transistors bipolaires à grille isolée.

5. Procédé selon la revendication 4, **caractérisé en ce que** la tension de contrôle est zéro ou une valeur négative.

6. Procédé selon la revendication 1 ou 2, **caractérisé en ce que** l'électrode de contrôle est une grille, l'électrode d'entrée est un drain et l'électrode de sortie est une source.

7. Procédé selon la revendication 6, **caractérisé en ce que** les commutateurs semi-conducteurs (S₁, S₂) sont des transistors à effet de champ métal-oxyde-semi-conducteur ou des transistors à effet de champ à jonction de grille.

8. Agencement pour contrôler un premier commutateur semi-conducteur, lequel le premier commutateur semi-conducteur (S₁) est relié en série à un second commutateur semi-conducteur (S₂) entre les pôles (u_{dc+}, u_{dc-}) d'une source de tension à courant continu, chacun des commutateurs semi-conducteurs comportant une électrode de contrôle (g), une électrode d'entrée (c) et une électrode de sortie (e), dans lequel l'agencement comporte :
un moyen pour couper le premier commutateur semi-conducteur (S₁) en délivrant une tension de contrôle, qui coupe le premier commutateur semi-conducteur, par l'intermédiaire d'une résistance (R_{off1}, R_{off2}) à l'électrode de contrôle du premier commutateur semi-conducteur, **caractérisé en ce que** la résistance (R_{off1}, R_{off2}) est configurée pour posséder une première valeur, lorsqu'une tension (u_{ce,S2}) entre l'électrode d'entrée et l'électrode de sortie du second commutateur semi-conducteur (S₂) est supérieure à un seuil de tension, et **en ce que** la résistance (R_{off1}, R_{off2}) est configurée pour posséder une seconde valeur, lorsque la tension entre l'électrode d'entrée (c) et l'électrode de sortie (e) du second commutateur semi-conducteur (S₂) est inférieure au seuil de tension, dans lequel la seconde valeur de résistance est supérieure à la première valeur de résistance.

9. Agencement selon la revendication 8, **caractérisé en ce que** le seuil de tension est zéro ou une valeur positive en dessous d'une tension de la source de tension à courant continu.

10. Agencement selon la revendication 8 ou 9, **caractérisé en ce que** l'électrode de contrôle est une grille (g), l'électrode d'entrée est un collecteur (c) et l'électrode de sortie est un émetteur (e).

11. Agencement selon la revendication 10, **caractérisé en ce que** les commutateurs semi-conducteurs (S₁, S₂) sont des transistors bipolaires à grille isolée.

12. Agencement selon la revendication 11, **caractérisé en ce que** la tension de contrôle est zéro ou une valeur négative.

13. Agencement selon la revendication 8 ou 9, **caractérisé en ce que** l'électrode de contrôle est une grille, l'électrode d'entrée est un drain et l'électrode de sortie est une source.

14. Agencement selon la revendication 13, **caractérisé en ce que** les commutateurs semi-conducteurs (S₁, S₂) sont des transistors à effet de champ métal-oxyde-semi-conducteur ou des transistors à effet de champ à jonction de grille.

15. Agencement selon l'une quelconque des revendications 8 à 13, **caractérisé en ce que** l'agencement est un circuit de commande (10, 20).
